# EUROPEAN PATENT SPECIFICATION

(11) **EP 3 476 541 B1**
(45) Date of publication and mention of the grant of the patent: **30.11.2022**
(21) Application number: 18201243.5
(22) Date of filing: 18.10.2018
(51) Int. Cl.: B25B 9/00, B25G 1/04, B25G 1/12, H02G 1/02, H01R 11/14, B25G 3/20

(54) **REACH TOOL FOR USE IN LOW VOLTAGE APPLICATIONS**
ERREICHUNGSWERKZEUG ZUR VERWENDUNG IN NIEDERSPANNUNGSANWENDUNGEN
OUTIL DE PORTÉE À UTILISER DANS DES APPLICATIONS BASSE TENSION

(30) Priority: 20.10.2017 US 201762575109 P
(43) Date of publication of application: 01.05.2019
(73) Proprietor: OTIS Elevator Company, Farmington, CT 06032 (US)
(72) Inventor: BROWNE, Benjamin Alan, Stuart, Florida 34997 (US); RODRIGUEZ, Robert, Phoenix, AZ Arizona 85042 (US); KEANE, Ryan N., Farmington, CT Connecticut 06032 (US); DIX, Kevin J., Chicago, IL Illinois 60661 (US); BUCKLEY, Craig A., Bloomfield, CT Connecticut 06002 (US)
(74) Representative: Dehns

(56) References cited:
- DE-U1- 20 005 517
- GB-A- 2 412 346
- US-A- 2 291 593
- US-A1- 2005 034 884
- US-B1- 6 283 519

## Description

### BACKGROUND

The subject matter disclosed herein relates to person safety equipment, and more specifically, the disclosure relates to a hand held reach tool for use in electrical applications.

Hand-held electrical probes are known in the art for detecting the presence of AC signal potential on a conductor. One type of probe requires direct electrical contact with an uninsulated portion of the conductor. There is a safety risk associated with the contacting type probes due to the possibility that the user may receive a harmful electrical shock.

US6283519 discloses a lighting rod having a reach rod with a holder hook on a hook end and a hook releaser on a handle end. US2291593 discloses a telescoping insulating stick adapted to be used for supporting disconnects and or other types of tools or for use in measuring distances. DE20005517U1 discloses screwing, turning and holding tools based on spirally wound tapes. GB2412346A discloses an apparatus for opening and closing a window. US2005/0034884A1 discloses a wildlife guard placement tool for installing a wildlife protection guard on an insulator of an elevated, electrical power distribution system.

### BRIEF DESCRIPTION

According to the claimed invention there is provided a hot stick for manipulating a probe from a position a selected distance away from a workpiece, including an arm, a connector coupled to the arm, the connector including a connector body having a contoured first surface, and a mechanism movable relative to the connector body and configured to cooperate with the first surface of the body to retain a probe, wherein the mechanism is slidable within a channel formed in the connector body, the mechanism being selectively retained at a plurality of locations relative to the connector body.

In addition to one or more of the features described above, in further embodiments the hot stick is suitable for use in applications where the workpiece has 1000 volts or less.

In addition to one or more of the features described above, or as an alternative, in further embodiments the hot stick is suitable for use in applications where the workpiece has 600 volts or less.

In addition to one or more of the features described above, or as an alternative, in further embodiments the arm is a telescoping arm comprising a plurality of sections movable between a retracted position and an extended position.

In addition to one or more of the features described above, or as an alternative, in further embodiments a resilient locking mechanism retains the arm in one of the extended position and the retracted position.

In addition to one or more of the features described above, or as an alternative, in further embodiments a gripping material is positioned adjacent a first end of the arm.

In addition to one or more of the features described above, or as an alternative, in further embodiments the arm, connector, and mechanism are formed from a non-conductive material.

In addition to one or more of the features described above, or as an alternative, in further embodiments the mechanism includes an engagement portion located generally adjacent the first surface of the connector body, at least one of the engagement portion and the first surface having an insert for gripping the probe coupled thereto.

In addition to one or more of the features described above, or as an alternative, in further embodiments the mechanism is a strap having at least one end removably coupled to the connector body.

In addition to one or more of the features described above, or as an alternative, in further embodiments the strap is formed from a Velcro material.

In addition to one or more of the features described above, or as an alternative, in further embodiments the connector body includes an elongated member operable to translate a button along an axis.

In addition to one or more of the features described above, or as an alternative, in further embodiments the connector body includes at least one feature operable to rotate a button about an axis.

In addition to one or more of the features described above, or as an alternative, in further embodiments the at least one feature includes a substantially identical first feature and second feature, the first feature and the second feature being generally symmetrical about a corresponding surface of the connector body.

In addition to one or more of the features described above, or as an alternative, in further embodiments the second feature is rotated 180 degrees relative to the first feature.

In addition to one or more of the features described above, or as an alternative, in further embodiments a clearance is defined between the first feature and the second feature, the clearance being complementary to a channel of the button.

In addition to one or more of the features described above, or as an alternative, in further embodiments the button is an inspection button of an elevator.

In addition to one or more of the features described above, or as an alternative, in further embodiments the connector is fixedly attached to an end of the arm.

In addition to one or more of the features described above, or as an alternative, in further embodiments the connector is integrally formed with an end of the arm.

### BRIEF DESCRIPTION OF THE DRAWINGS

The subject matter, which is regarded as the disclosure, is particularly pointed out and distinctly claimed in the claims at the conclusion of the specification. The foregoing and other features, and advantages of the disclosure are apparent from the following detailed description taken in conjunction with the accompanying drawings in which:
FIG. 1 is a perspective view of a hot stick according to an embodiment;
FIG. 2 is a cross-sectional view of the hot stick of FIG. 1 in a retracted configuration according to an embodiment;
FIG. 3 is a cross-sectional view of the hot stick of FIG. 1 in an extended configuration according to an embodiment;
FIG. 4 is another perspective view of a hot stick according to an embodiment;
FIG. 5 is a perspective view of a hot stick having a probe mounted thereto according to an embodiment;
FIG. 6 is a perspective cross-sectional view of a hot stick according to an embodiment;
FIG. 7 is a perspective view of a hot stick according to another embodiment; and
FIG. 8 is a front view of a button having a channel feature according to an embodiment; and
FIG. 9 is a perspective view of portion of a hot stick having a probe mounted thereto according to an embodiment;

The detailed description explains embodiments of the disclosure, together with advantages and features, by way of example with reference to the drawings.

### DETAILED DESCRIPTION

Referring now to the FIGS., an example of tool 20 commonly referred to as a "hot stick" is illustrated. The tool 20 is configured to allow a user to manipulate a piece of equipment from a selected distance away from a workpiece. For example, in an embodiment, the tool 20 may be suitable for electrical use up to 600 volts per ASTM and CSA standards. Alternatively, the tool may be suitable for electrical use up to 750 or 1000 volts.

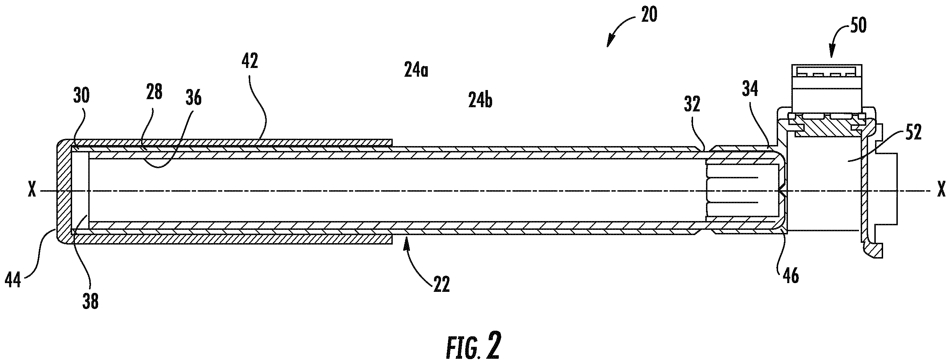

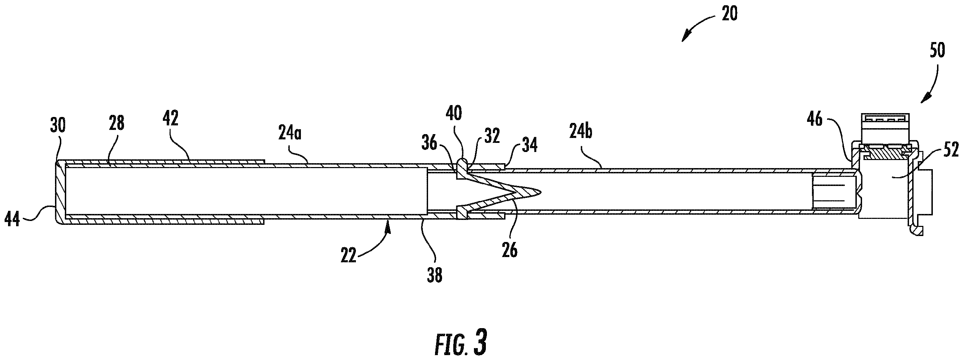

As shown, the tool 20 includes a telescoping arm 22 having a plurality of tubular sections 24 slidable along a longitudinal axis X of the tool 20 to vary the length thereof. In the illustrated, non-limiting embodiment, the arm 22 includes a first tubular section 24a and a second tubular section 24b movable between a retracted position (FIG. 2) and an extended position (FIG. 3). Although an arm 22 having only two tubular sections 24a, 24b is illustrated and described herein, it should be understood that an arm 22 having any number of sections 24 is within the scope of the disclosure. An outer diameter of the second tubular section 24b is smaller than an inner diameter of the first tubular section 24a such that all or a portion of the second tubular section 24b is receivable within a hollow interior of the first tubular section 24a. Accordingly, in the retracted position, all or a substantial portion of the first tubular section 24a and the second tubular section 24b are arranged in an overlapping configuration.

A locking mechanism 26 is operable to lock the arm 22 in one or more of the extended and retracted positions. The first tubular section 24a has a first hole 28 formed adjacent a first end 30 and a second hole 32 formed adjacent the second, opposite end 34. Similarly, the second tubular section 24b has a hole 36 formed adjacent a first end 38 thereof. When the arm 22 is in the retracted position, the first holes 28, 36 of the first and second tubular sections 24a, 24b are generally aligned such that the locking mechanism 26 engages the first holes 28, 36. Through this engagement, the second tubular section 24b is restricted from moving relative to the first tubular section 24a. In the extended position, the locking mechanism 26 engages the aligned first hole 36 of the second tubular section 24b and the second hole 32 of the first tubular section 24a to restrict relative movement between the first and second tubular sections 24a, 24b. In the extended position, the length of the arm 22 in combination with a user's arm is equal to or greater than a shock protection boundary set by industry electrical standards, such as NFPA 70E, for example. In an embodiment, the arm 22 has a length greater than or generally equal to about 21 inches in the extended position, and may be retracted to a length of between about 12 and 13 inches.

The locking mechanism 26 is a resilient member, such as a clip mounted to the second tubular section 24b for example, having at least one protrusion or detent 40 receivable within the holes 28, 32, 36. A biasing force of the locking mechanism 26 biases the detent 40 outwardly and into engagement with one or more holes 36, and 28 or 32. When the detent 40 is engaged with a pair of aligned holes, the locking mechanism 26 may be able to withstand at least three pounds of shear force applied to the tubular sections 24a, 24b of the arm 22.

To disengage the locking mechanism 26 from a hole 28 or 32 of the first arm section 24a, an inward force is applied thereto. When the detent 40 is disengaged from a hole 28 or 32 of the first tubular section 24a, the arm 22 is movable between the extended and retracted position. Although the arm 22 is described as telescoping, embodiments where the arm 22 is formed having a stationary length are also within the scope of the disclosure. Further, regardless of the configuration, the arm 22 is formed from a suitable non-conductive material, such as plastic for example. The arm may additionally include a coating to prevent great and dirt from accumulating thereon.

A material 42 intended to provide a surface for easily gripping the arm 22 is wrapped about at least a portion of the arm 22. Although the gripping material 42 is illustrated as being located at a first end 44 of the arm, adjacent the first end 30 of the first tubular section 24a, and has a length equal to about 6 inches, embodiments where the gripping material 42 spans an entire length of the first tubular section 24a or of the entire arm 22 are also within the scope of the disclosure. In an embodiment, the material 42 is a rubberized or foam material. However, any suitable non-conductive material is contemplated herein.

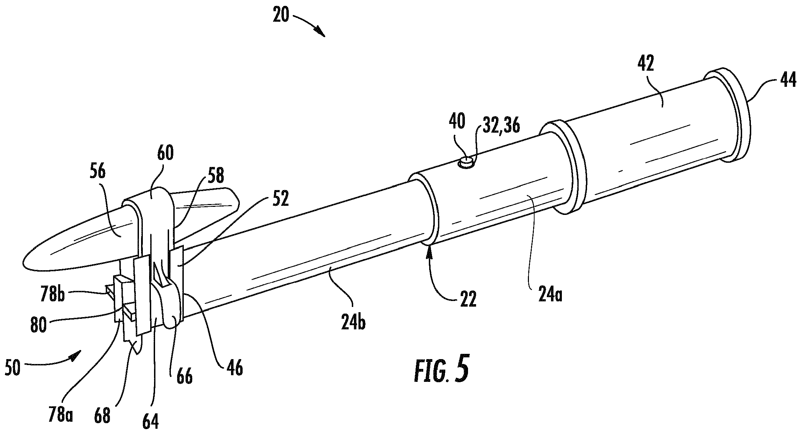

Located at the distal end 46 of the arm 22, opposite the gripping material 42, is a connector 50. The connector 50 may be removably coupled to or fixedly attached to the arm 22. As shown, the body 52 of the connector 50 is generally rectangular in shape. However, any suitable shape is within the scope of the disclosure. A first surface 54 of the connector 50 includes a generally non-planar surface. In an embodiment, the contour of the first surface 54 is generally complementary to a probe or other device 56 (see FIG. 5) to be used with the tool 20. Examples of probes or other devices 56 suitable with the tool 20 include, but are not limited to, a proximity tester and a meter probe for example.

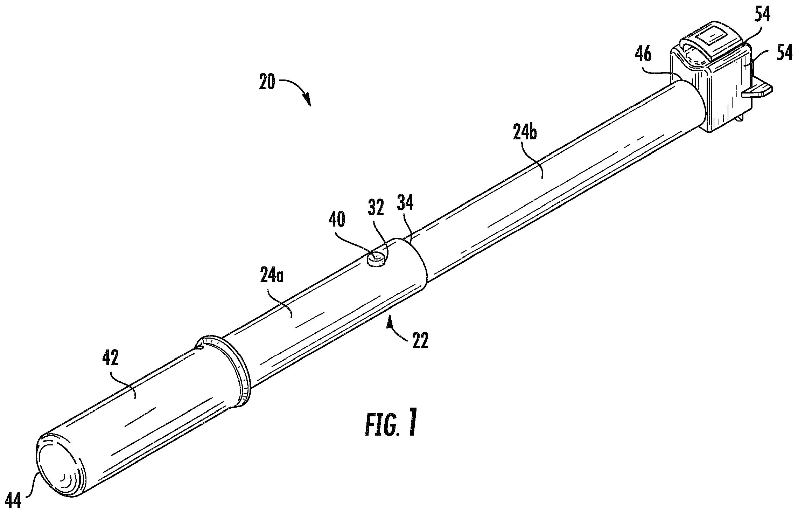

The connector 50 additionally includes a mechanism 58 configured to cooperate with the body 52 to retain or hold the probe or other device 56. In the non-limiting embodiment of FIGS. 1-7, the mechanism 58 includes an engagement portion 60 disposed adjacent the first surface 54. The engagement portion 60 may also, but need not, have a contour generally complementary to a portion of the probe or other device 56. In an embodiment, one or both of the first surface 54 and the engagement portion 60 includes an insert 62 having an enhanced gripping surface for preventing movement of a device in contact therewith.

The mechanism 58 is movable to compress the device 56 between the first surface 54 and the engagement portion 60 thereof, best shown in FIG. 5. The mechanism 58 in combination with the connector 50 is suitable to retain a variety of devices 56 even when a force of up to three pounds is applied thereto in all directions. In the illustrated, non-limiting embodiment, the mechanism 58 is movable about an axis Y oriented substantially perpendicular to the longitudinal axis X of the arm 22. However, embodiments where the arm 22 is movable about an axis parallel to the longitudinal axis X or is rotatable about an axis for example, are also within the scope of the disclosure.

The mechanism 58 is slidable within a channel 64 formed at a side of the connector 50 to position the engagement portion 60 relative to the first surface 54. The mechanism 58 functions in a manner similar to a ratchet such that the mechanism 58 is held or selectively retained at one of a plurality of positions relative to the connector body 52. The mechanism 58 may include a tab or other feature 66 to allow a user to easily manipulate the position of the mechanism 58 relative to the connector body 54.

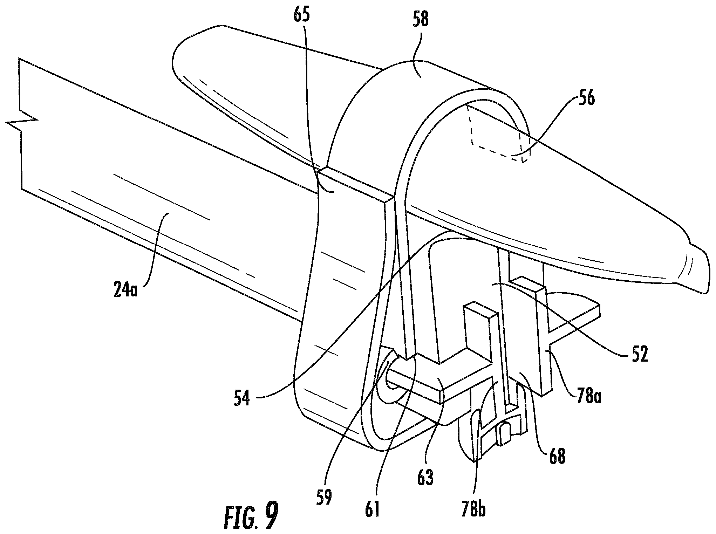

In another embodiment, best shown in FIG. 9, the movable mechanism 58 includes a strap coupled to the body 52 of the connector 50. For example, a first end 59 of the strap may extend through a slot 61 formed in the body 52, such as in a flange 63 extending from a side thereof. The strap 58 is configured to wrap around the probe or other device 56 to compress the device 56 between the first surface 54 and the mechanism 58. The movable or free end 65 of the strap 58 may be configured to removably couple to a portion of the connector 50, or alternatively, may couple to another portion of the strap 58, as shown in the FIG. In an embodiment, the strap 58 is formed from a Velcro material; however any suitable strap-like mechanism is contemplated herein.

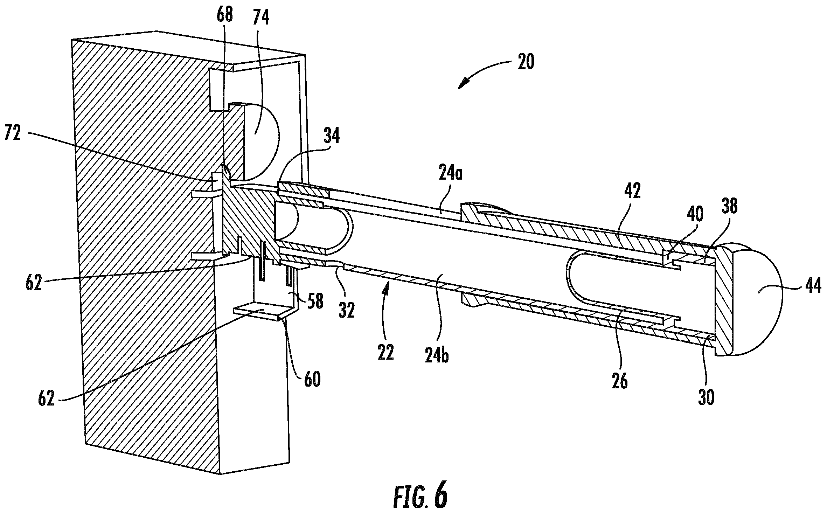

The tool 20 may additionally be adapted to manipulate one or more buttons. In such embodiments, an elongated member 68 may extend from a surface of the connector body 52. Although the elongated member 68 is illustrated as being positioned at a surface 70 of the connector body 52 opposite the portion of the connector 50 mounted to the arm 22, the elongated member 68 may be disposed at any location about the connector 50. As best shown in FIG. 6, the thickness of the elongated member 68 is sized such that the elongated member 68 may be inserted between a mounting surface 72 and a button 74 movable axially towards and away from the plane of the mounting surface 72. Accordingly, the elongated member 68b may be used to push or pull the button 74 in a desired direction.

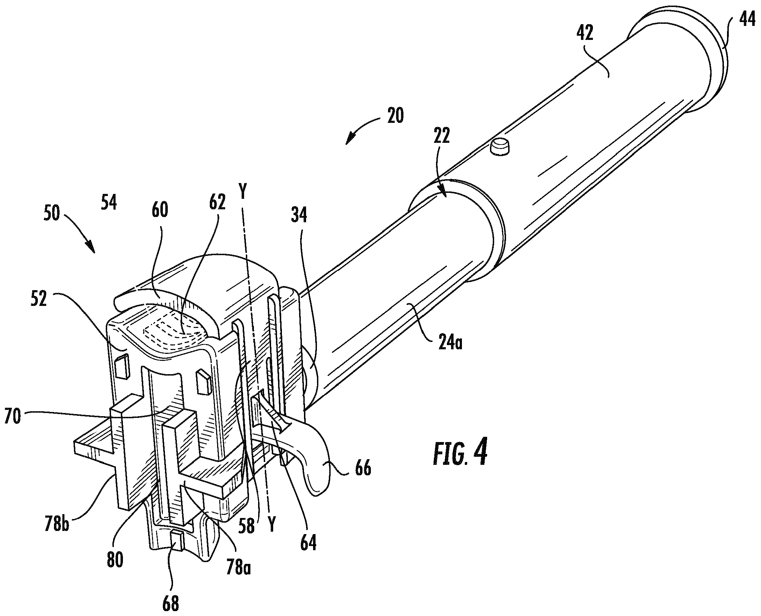

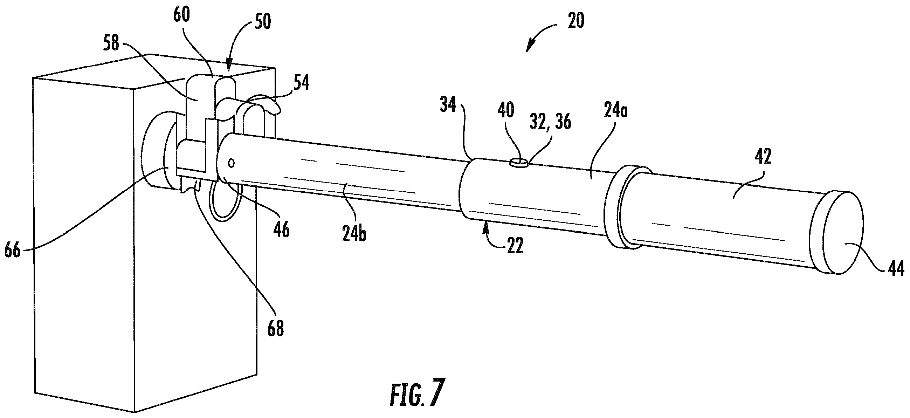

In an embodiment, the tool 20 is adapted for use in elevator applications. In such embodiments, the connector 50 includes at least one feature 78 configured to engage and facilitate rotation of a corresponding button or knob 76, such as a button for controlling operation of the elevator car in an inspection mode for example. With reference to FIGS. 4 and 7, in the illustrated, non-limiting embodiment, the connector body 52 includes a first feature 78a and a substantially identical second feature 78b. However, any number of features is contemplated herein. The features are rotated 180 degrees relative to one another such that the features are generally symmetrical about the corresponding surface 70 of the connector body 52. In embodiments where a shroud surrounds the button, as shown in FIG. 7, the diameter defined by the plurality of features 78 is less than the diameter of the shroud for receipt therein. However, the features 78 may act to stabilize the tool 20 when being used in other applications. For example, the diameter defined by the features 78 may exceed a shroud associated with another button, such as a run button of an elevator control, thereby preventing accidental engagement with the button.

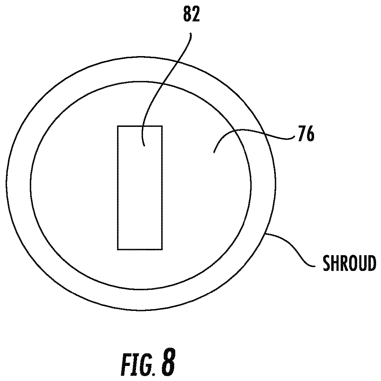

In the illustrated, non-limiting embodiment, the first and second features 78a, 78b are horizontally oriented, generally T-shaped members that define a channel or clearance 80 there between. The channel 80 is complementary to a channel 82 formed in and protruding from the button 76 (see FIG. 8). In use, a user can position the tool 20 such that the channel 82 of the button 76 is received within the channel 80 formed between the features 78a, 78b. Once aligned, the user may rotate the tool 20 in a desired direction to turn the button 76. It should be understood that the features 78 illustrated and described herein are specific to one type of button and that features having another configuration adapted for use with a different type of button are also within the scope of the disclosure.

While the disclosure has been described in detail in connection with only a limited number of embodiments, it should be readily understood that the disclosure is not limited to such disclosed embodiments. Rather, the disclosure can be modified to incorporate any number of variations, alterations, substitutions or equivalent arrangements not heretofore described, but which are commensurate with the scope of the claims. Additionally, while various embodiments of the disclosure have been described, it is to be understood that aspects of the disclosure may include only some of the described embodiments. Accordingly, the disclosure is not to be seen as limited by the foregoing description, but is only limited by the scope of the appended claims.

## Claims

1. A hot stick (20) for manipulating a probe from a position a selected distance away from a workpiece, the hot stick comprising:
an arm (22);
a connector (50) coupled to the arm (22), the connector (50) including a connector body (52) having a first surface (54); and
a mechanism (58) movable relative to the connector body (52) and configured to cooperate with the first surface (54, 70) of the connector body (52) to retain a probe (56),
wherein the mechanism (58) is slidable within a channel (64) formed in the connector body (52),
**characterised in that**:
the first surface (54) is contoured; and
the mechanism (58) is selectively retained at a plurality of locations relative to the connector body (52).

2. The hot stick (20) of claim 1, wherein the hot stick (20) is suitable for use in applications where the workpiece has 1000 volts or less; preferably 600 volts or less.

3. The hot stick (20) of claim 1 or 2, wherein the arm (22) is a telescoping arm comprising a plurality of sections (24a, 24b) movable between a retracted position and an extended position.

4. The hot stick (20) of claim 3, wherein a resilient locking mechanism (26) retains the arm (22) in one of the extended position and the retracted position.

5. The hot stick (20) of any preceding claim, wherein a gripping material (42) is positioned adjacent a first end (44) of the arm (22).

6. The hot stick (20) of any preceding claim, wherein the arm (22), the connector (50), and the mechanism (58) are formed from a non-conductive material.

7. The hot stick (20) of any preceding claim, wherein the mechanism (58) includes an engagement portion (60) located generally adjacent the first surface (54) of the connector body (52), at least one of the engagement portion (60) and the first (54) surface having an insert (62) for gripping the probe (56) coupled thereto.

8. The hot stick (20) of any preceding claim, wherein the mechanism (58) is a strap (58) having at least one end (65) removably coupled to the connector body (52).

9. The hot stick (20) of any preceding claim, wherein the connector body (52) includes an elongated member (68) operable to translate a button (74) along an axis; and preferably wherein the button (74) is an inspection button of an elevator.

10. The hot stick (20) of any preceding claim, wherein the connector body (52) includes at least one feature (78) operable to rotate a button (76) about an axis.

11. The hot stick (20) of claim 10, wherein the at least one feature includes a substantially identical first feature (78a) and second feature (78a), the first feature (78a) and the second feature (78b) being generally symmetrical about a corresponding surface (70) of the connector body (52).

12. The hot stick (20) of claim 11, wherein the second feature (78b) is rotated 180 degrees relative to the first feature (78a).

13. The hot stick (20) of claim 11 or 12, wherein a clearance (80) is defined between the first feature (78a) and the second feature (78b), the clearance (80) being complementary to a channel (82) of the button (76).

14. The hot stick (20) of any preceding claim, wherein the connector (50) is fixedly attached to an end of the arm (22); or wherein the connector (50) is integrally formed with an end of the arm (22).

## Patentansprüche

1. Isolierstange (20) zum Manipulieren einer Sonde von einer Position in einem ausgewählten Abstand von einem Werkstück entfernt, wobei die Isolierstange umfasst:
einen Arm (22);
einen Verbinder (50), der mit dem Arm (22) gekoppelt ist, wobei der Verbinder (50) einen Verbinderkörper (52) beinhaltet, der eine erste Oberfläche (54) aufweist; und
einen Mechanismus (58), der relativ zu dem Verbinderkörper (52) bewegbar und dazu konfiguriert ist, mit der ersten Oberfläche (54, 70) des Verbinderkörpers (52) zusammenzuwirken, um eine Sonde (56) zu halten,
wobei der Mechanismus (58) in einem Kanal (64), der in dem Verbinderkörper (52) gebildet ist, verschiebbar ist,
**dadurch gekennzeichnet, dass**:
die erste Oberfläche (54) konturiert ist; und
der Mechanismus (58) selektiv an einer Vielzahl von Stellen relativ zu dem Verbinderkörper (52) gehalten wird.

2. Isolierstange (20) nach Anspruch 1, wobei die Isolierstange (20) zur Verwendung bei Anwendungen geeignet ist, bei welchen das Werkstück 1000 Volt oder weniger aufweist; bevorzugt 600 Volt oder weniger.

3. Isolierstange (20) nach Anspruch 1 oder 2, wobei der Arm (22) ein Teleskoparm ist, der eine Vielzahl von Abschnitten (24a, 24b) umfasst, die zwischen einer zurückgezogenen Position und einer ausgefahrenen Position bewegbar ist.

4. Isolierstange (20) nach Anspruch 3, wobei ein elastischer Verriegelungsmechanismus (26) den Arm (22) in einer der ausgefahrenen Position und der zurückgezogenen Position hält.

5. Isolierstange (20) nach einem vorstehenden Anspruch, wobei ein Greifmaterial (42) an ein erstes Ende (44) des Arms (22) angrenzend positioniert ist.

6. Isolierstange (20) nach einem vorstehenden Anspruch, wobei der Arm (22), der Verbinder (50) und der Mechanismus (58) aus einem nichtleitenden Material gebildet sind.

7. Isolierstange (20) nach einem vorstehenden Anspruch, wobei der Mechanismus (58) einen Eingriffsabschnitt (60) beinhaltet, der allgemein an die erste Oberfläche (54) des Verbinderkörpers (52) angrenzend liegt, wobei mindestens einer des Eingriffsabschnitts (60) und der ersten (54) Oberfläche einen Einsatz (62) zum Greifen der gekoppelten Sonde (56), die daran gekoppelt ist, aufweist.

8. Isolierstange (20) nach einem vorstehenden Anspruch, wobei der Mechanismus (58) ein Gurt (58) ist, der mindestens ein Ende (65) aufweist, das lösbar an den Verbinderkörper (52) gekoppelt ist.

9. Isolierstange (20) nach einem vorstehenden Anspruch, wobei der Verbinderkörper (52) ein längliches Element (68) beinhaltet, das betätigbar ist, um einen Knopf (74) entlang einer Achse zu verschieben; und wobei der Knopf (74) bevorzugt ein Inspektionsknopf eines Aufzugs ist.

10. Isolierstange (20) nach einem vorstehenden Anspruch, wobei der Verbinderkörper (52) mindestens ein Merkmal (78) beinhaltet, das betätigbar ist, um einen Knopf (76) um eine Achse zu drehen.

11. Isolierstange (20) nach Anspruch 10, wobei das mindestens eine Merkmal ein im Wesentlichen identisches erstes Merkmal (78a) und zweites Merkmal (78a) beinhaltet, wobei das erste Merkmal (78a) und das zweite Merkmal (78b) allgemein um eine entsprechende Oberfläche (70) des Verbinderkörpers (52) symmetrisch sind.

12. Isolierstange (20) nach Anspruch 11, wobei das zweite Merkmal (78b) relativ zu dem ersten Merkmal (78a) um 180 Grad gedreht ist.

13. Isolierstange (20) nach Anspruch 11 oder 12, wobei zwischen dem ersten Merkmal (78a) und dem zweiten Merkmal (78b) ein Zwischenraum (80) definiert ist, wobei der Zwischenraum (80) zu einem Kanal (82) des Knopfs (76) komplementär ist.

14. Isolierstange (20) nach einem vorstehenden Anspruch, wobei der Verbinder (50) fest an einem Ende des Arms (22) angebracht ist; oder wobei der Verbinder (50) einstückig mit einem Ende des Arms (22) gebildet ist.

## Revendications

1. Perche isolée (20) pour manipuler une sonde à partir d'une position se trouvant à une distance sélectionnée d'une pièce à travailler, la perche isolée comprenant :
un bras (22) ;
un connecteur (50) couplé au bras (22), le connecteur (50) comportant un corps de connecteur (52) ayant une première surface (54) ; et
un mécanisme (58) mobile par rapport au corps de connecteur (52) et configuré pour coopérer avec la première surface (54, 70) du corps de connecteur (52) pour retenir une sonde (56),
dans laquelle le mécanisme (58) peut coulisser dans un canal (64) formé dans le corps de connecteur (52),
**caractérisée en ce que** :
la première surface (54) est profilée ; et
le mécanisme (58) est sélectivement retenu à une pluralité d'emplacements par rapport au corps de connecteur (52).

2. Perche isolée (20) selon la revendication 1, dans laquelle la perche isolée (20) est adaptée pour être utilisée dans des applications où la pièce à travailler a 1000 volts ou moins ; de préférence 600 volts ou moins.

3. Perche isolée (20) selon la revendication 1 ou 2, dans laquelle le bras (22) est un bras télescopique comprenant une pluralité de tronçons (24a, 24b) mobiles entre une position rétractée et une position déployée.

4. Perche isolée (20) selon la revendication 3, dans laquelle un mécanisme de verrouillage élastique (26) retient le bras (22) dans l'une parmi la position déployée et la position rétractée.

5. Perche isolée (20) selon une quelconque revendication précédente, dans laquelle un matériau de préhension (42) est positionné adjacent à une première extrémité (44) du bras (22).

6. Perche isolée (20) selon une quelconque revendication précédente, dans laquelle le bras (22), le connecteur (50) et le mécanisme (58) sont formés à partir d'un matériau non conducteur.

7. Perche isolée (20) selon une quelconque revendication précédente, dans laquelle le mécanisme (58) comporte une partie de prise (60) située généralement adjacente à la première surface (54) du corps de connecteur (52), au moins l'une de la partie de prise (60) et de la première surface (54) ayant une partie d'insertion (62) pour saisir la sonde (56) couplée à celle-ci.

8. Perche isolée (20) selon une quelconque revendication précédente, dans laquelle le mécanisme (58) est une sangle (58) ayant au moins une extrémité (65) couplée de manière amovible au corps de connecteur (52).

9. Perche isolée (20) selon une quelconque revendication précédente, dans laquelle le corps de connecteur (52) comporte un organe allongé (68) pouvant fonctionner pour déplacer en translation un bouton (74) le long d'un axe ; et de préférence dans laquelle le bouton (74) est un bouton d'inspection d'un ascenseur.

10. Perche isolée (20) selon une quelconque revendication précédente, dans laquelle le corps de connecteur (52) comporte au moins un élément (78) pouvant fonctionner pour faire tourner un bouton (76) autour d'un axe.

11. Perche isolée (20) selon la revendication 10, dans laquelle l'au moins un élément comporte un premier élément (78a) et un second élément (78a) sensiblement identiques, le premier élément (78a) et le second élément (78b) étant généralement symétriques autour d'une surface correspondante (70) du corps de connecteur (52) .

12. Perche isolée (20) selon la revendication 11, dans laquelle le second élément (78b) est tourné de 180 degrés par rapport au premier élément (78a).

13. Perche isolée (20) selon la revendication 11 ou 12, dans laquelle un jeu (80) est défini entre le premier élément (78a) et le second élément (78b), le jeu (80) étant complémentaire d'un canal (82) du bouton (76).

14. Perche isolée (20) selon une quelconque revendication précédente, dans laquelle le connecteur (50) est attaché de manière fixe à une extrémité du bras (22) ; ou dans laquelle le connecteur (50) est formé d'un seul tenant avec une extrémité du bras (22).
